## Europäisches Patentamt
## European Patent Office
## Office européen des brevets

(19)

(11) Numéro de publication: **0 081 259 B1**

---

(12) # FASCICULE DE BREVET EUROPEEN

(45) Date de publication du fascicule du brevet: **31.07.85**

(51) Int. Cl.⁴: **H 03 D 9/06**, H 03 D 7/12

(21) Numéro de dépôt: **82201493.2**

(22) Date de dépôt: **25.11.82**

---

(54) **Combineur-mélangeur à transistor double source.**

---

(30) Priorité: **27.11.81 FR 8122253**

(43) Date de publication de la demande:
**15.06.83 Bulletin 83/24**

(45) Mention de la délivrance du brevet:
**31.07.85 Bulletin 85/31**

(84) Etats contractants désignés:
**DE FR GB**

(56) Documents cités:
**FR - A - 2 350 728**
**FR - A - 2 460 049**
**FR - A - 2 477 828**

**1977 IEEE MTT-S INTERNATIONAL MICROWAVE SYMPOSIUM DIGEST, 21-23 juin 1977, San Diego, pages 285-287, New York (USA); S.C. CRIPPS et al.: "An experimental evaluation of X-band GaAs FET mixers using single and dual-gate devices"**
**PHILIPS TECHNICAL REVIEW, vol. 39, no. 10, octobre 1980, pages 269-276, Eindhoven (NL); P. BAUDET et al.: "Low-noise microwave GaAs field-effect transistor"**
**PHILIPS TECHNICAL REVIEW, vol. 39, no. 10, octobre 1980, pages 257-268, Eindhoven (NL); P. HARROP et al.: "Low-noise 12GHz front-end designs for direct satellite television reception"**

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **DE GB**

(72) Inventeur: **Harrop, Peter, Société Civile S.P.I.D. 209 rue de l'Université, F-75007 Paris (FR)**

(74) Mandataire: **Gendraud, Pierre et al, Société Civile S.P.I.D. 209, rue de l'Université, F-75007 Paris (FR)**

---

BUNDESDRUCKEREI BERLIN

## Description

L'invention concerne un circuit de combinaison hyperfréquences, du type comprenant deux entrées et une sortie, au moyen duquel le signal de sortie obtenu est la somme des deux signaux d'entrée; l'invention concerne également un circuit de combinaison et de mélange hyperfréquences comportant un tel circuit au moyen duquel le signal de sortie obtenu est le mélange des deux signaux d'entrée.

L'invention a trait aux transmissions de signaux, par exemple par satellites artificiels, et plus spécifiquement aux circuits de réception et de traitement de ces signaux. Le circuit selon l'invention concerne la transposition de fréquences à effectuer entre la fréquence d'émission des signaux (par exemple, pour les systèmes de télédistribution par satellites artificiels, cette fréquence peut être comprise entre 11,5 et 12,5 GHz), et une fréquence intermédiaire (par exemple de 1 GHz, pour ces mêmes systèmes).

Le choix des fréquences pour les systèmes de télédistribution (et même, plus généralement, de télécommunications) est conditionné par le milieu dans lequel vont être ces signaux, et par la puissance disponible dans la station émettrice. La qualité d'un signal n'est acceptable que lorsque le rapport du niveau du signal utile au bruit perturbateur est suffisamment grand. Or, une partie de ce bruit est recueillie par l'antenne de réception, et une autre partie est produite dans le récepteur. Le bruit recueilli par l'antenne ne peut être réduit que par un choix judicieux des fréquences.

Les fréquences de fonctionnement sont dont choisies dans les fenêtres radioélectriques, globalement entre 0,5 et 50 GHz. Et, les bandes de fréquences, récemment attribuées par le CCIR pour la télédistribution par satellite artificiel sont comprises entre 11,7 et 12,5 GHz.

Le signal émis par le satellite à haute fréquence est reçu à terre par une station communautaire ou individuelle et converti en un signal de plus basse fréquence, de façon à être accepté par un appareil de télévision standard. En fait, ce changement de fréquences s'effectue en plusieurs étapes: un premier changement de fréquence, de la fréquence d'émission (12 GHz) à une fréquence intermédiaire (1 GHz), d'autres changements de fréquence ayant lieu ultérieurement jusqu'à la fréquence d'environ 130 MHz, à laquelle s'effectue la démodulation de fréquence et la modulation d'amplitude d'une fréquence porteuse qui sera appliquée à un récepteur de télévision standard.

Selon l'art antérieur, les changements de fréquences étaient effectués au moyen d'une diode Schottky, à haute fréquence de coupoure ou d'un transistor à effet de champ par exemple, suivie d'un filtre adéquat destiné à sélectionner parmi les diverses fréquences présentes en sortie, la fréquence désirée. Une telle réalisation supposait des lignes de transmission, par exemple de type microrubans, et un moyen de couplage pour fournir à l'entrée de ladite diode les signaux à mélanger.

Une telle réalisation présente un inconvénient principal, celui d'un encombrement par trop important.

C'est pourquoi, en premier lieu, la présente invention propose un circuit de combinaison hyperfréquences, du type comprenant deux entrées et une sortie, au moyen duquel le signal de sortie obtenu est la somme des deux signaux d'entrée, caractérisé en ce qu'il comporte un seul transistor à effet de champ double source, monté en grille commune, alors que les deux signaux d'entrée sont appliqués sur les deux électrodes de source et que le signal de sortie est obtenu sur l'unique électrode de drain; et en second lieu, un circuit de combinaison et de mélange hyperfréquences comportant le circuit de combinaison décrit ci-dessus, du type comprenant au moins deux entrées et une sortie, au moyen duquel le signal de sortie obtenu est le mélange des deux signaux d'entrée, caractérisé en ce que le signal de sortie de ce premier circuit est appliqué, au travers d'une adaption d'impédance, à l'électrode de grille d'un transistor à effet de champ, monté en source commune, dont la tension de polarisation est telle qu'il fonctionne dans une région de sa courbe $I_D = f(V_{GS})$ non linéaire, et que le signal de sortie de ce circuit de combinaison et de mélange est obtenu sur l'électrode de drain de ce transistor à effet de champ.

La présente invention permet ainsi de pallier l'inconvénient cité comme inhérent à l'art antérieur en proposant de tels circuits caractérisés en ce qu'ils sont monolithiquement intégrés sur un substrat semiconducteur, tel que l'arséniure de gallium.

La description qui va suivre, en regard des dessins annexés donnés à titre non limitatif, permettra de mieux comprendre et mesurer la portée de l'invention.

La figure 1 représente un diagramme synoptique de la réception et de la transposition de fréquences d'un signal.

La figure 2 représente une réalisation selon l'art antérieur de ce circuit.

La figure 3 représente la réalisation d'un circuit de combinaison et de mélange de deux signaux.

La figure 4 représente un transistor double source.

La figure 5 représente le circuit de combinaison, selon la présente invention, et la figure 6, le circuit de combinaison et de mélange, selon la présente invention.

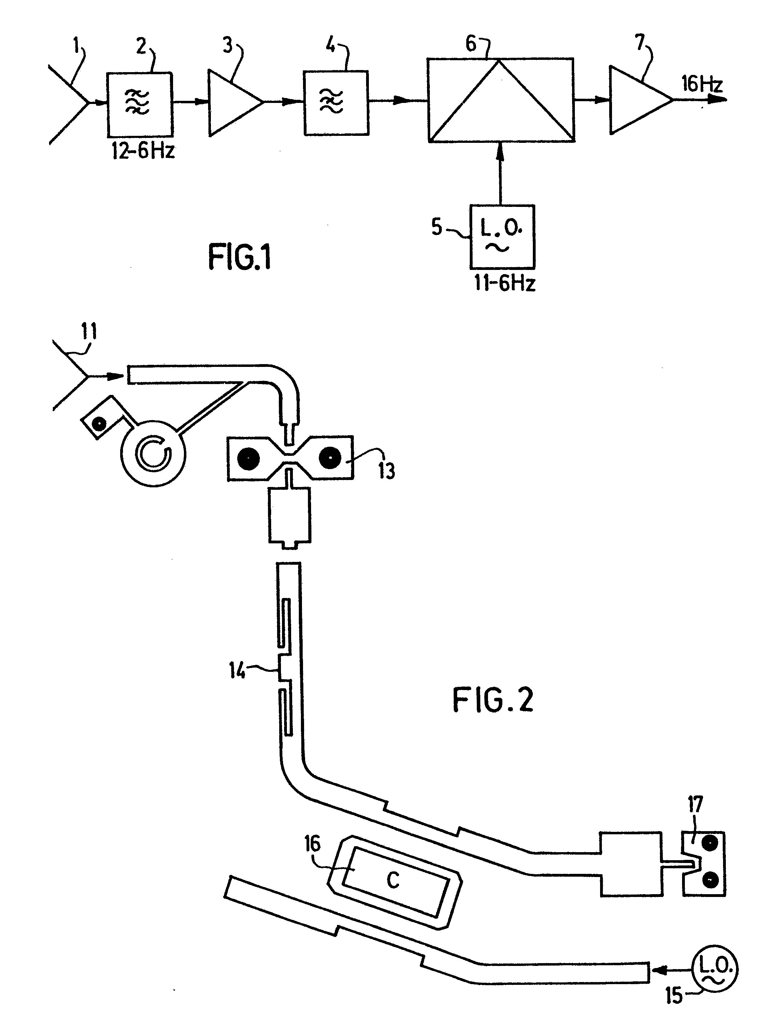

Le diagramme synoptique, selon la figure 1, représente le dispositif de réception et de transposition de fréquences d'un signal reçu, par exemple d'un satellite, et qui est disposé généralement à proximité de l'antenne, dans ce que l'on appelle usellement la »tête de réception«. Ce dispositif se compose donc d'une antenne 1, sous la forme d'un réflecteur parabolique, d'un diamètre voisin d'un mètre, au foyer duquel se trouve la tête de réception proprement dite qui comprend: un filtre passe-bande 2, un préamplificateur (12 GHz), référencé 3, un filtre à réjection de fréquence 4 destine à éviter la transmission de signaux de fréquences parasites non désirées, un mélangeur 6 à une autre entrée duquel est appliqué le signal (de 11 GHz) provenant d'un oscillateur local 5, par exemple un transistor à effet de champ, et un amplificateur 7 de fréquence intermédiaire (1 GHz).

Un exemple de réalisation, selon l'art antérieur, de ce circuit est représenté à la figure 2. Sur un support, par exemple en alumine, on réalise selon la technologie connue des microrubans, une première ligne de transmission sur laquelle est envoyé le signal provenant de l'antenne 11. Ce signal est appliqué à la grille d'un transistor à effet de champ 13 dont la source est reliée à la terre par deux trous métallisés. La tension de polarisation est appliquée à ce transistor 13, au travers d'un filtre à structure circulaire, conçu par la Demanderesse et protégé par une précédente demande de brevet, déposée le 25 juin 1979, et publiée sous le numéro FR-A-2 460 049. De façon à minimiser le bruit, une adaptation d'impédance est réalisée sous la forme d'une ligne étroite d'impédance élevée, suivie d'une ligne quart d'onde de faible impédance. Un filtre 14, à coupure de bande, est réalisé sous la forme d'échancrures en »ergots« (en anglo-saxon: »spur-line filter«). Sur une seconde ligne de transmission est envoyé le signal provenent de l'oscillateur local 15. Ce signal est couplé au moyen d'un coupleur directionnel 16, et les deux signaux sont appliqués sur la première ligne de transmission à l'électrode de grille d'un transistor à effet de champ 17, dans lequel s'opère le mélange des deux signaux.

Pour de plus amples informations sur l'art antérieur, il peut être intéressant de consulter la revue PHILIPS TECHNICAL REVIEW, volume 39, 1980, n° 10, et plus particulièrement l'article intitulé: »Low-noise 12 GHz front end designs for direct satellite television reception« par P. HARROP, P. LESARTRE et T. H. A. M. VLEK. Un procédé particulier de réalisation de ces échancrures en »ergots«, est décrit et protégé par une précédente demande de brevet déposée au nom de la Demanderesse en date du 7 mars 1980 et publiée sous le numéro FR-A-2 477 829.

Cette réalisation selon l'art antérieur présente l'inconvénient principal d'un encombrement trop important. L'intégration des têtes de réception nécessite de concevoir des solutions monolithiques avant d'obtenir dans un proche futur des solutions totalement intégrées sur un substrat d'arséniure de gallium. L'invention vise à pallier cet inconvénient en proposant une réalisation plus compacte.

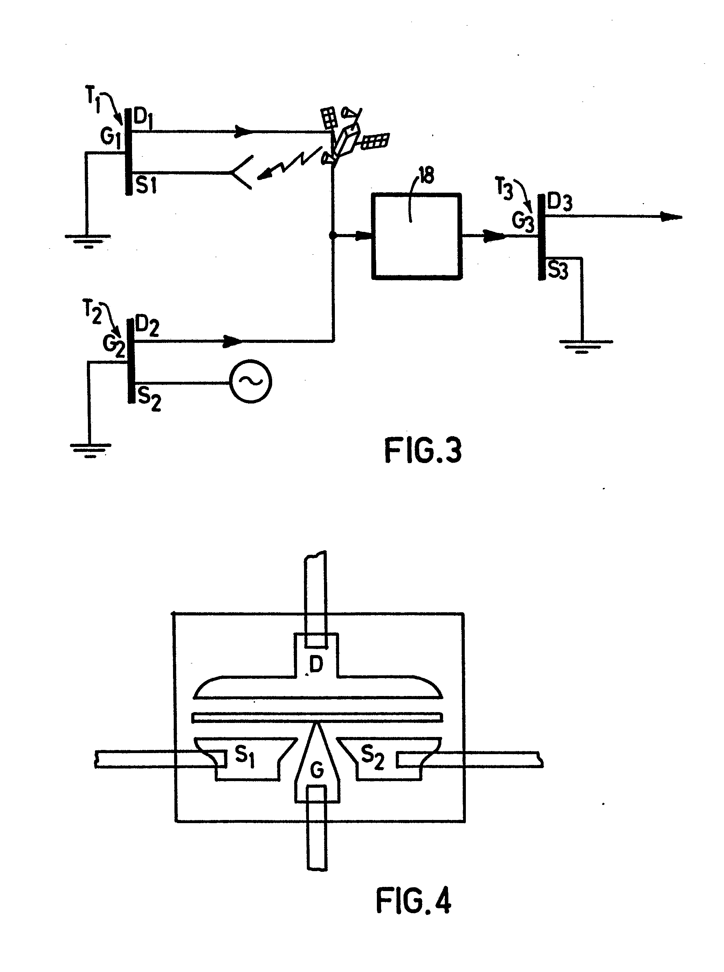

La figure 3 représente le circuit de combinaison et de mélange, réalisé au moyen de transistors à effet de champ. Les signaux à combiner sont appliqués aux sources $S_1$ et $S_2$ des deux transistors à effet de champ $T_1$ et $T_2$ montés en grille commune. Les signaux récupérés sur les électrodes de drain $D_1$ et $D_2$ sont appliqués ensemble sur l'électrode de grille $G_3$ d'un transistor à effet de champ $T_3$ monté en source commune.

Le premier étage de ce circuit, constitué par les deux transistors $T_1$ et $T_2$ montés en grille commune, réalise une adaptation d'impédance de telle sorte que les deux signaux, l'un provenant par exemple du satellite, de fréquence 12 GHz, et l'autre provenant par exemple d'un oscillateur local, de fréquence 11 GHz, soient appliqués chacun à un circuit dont l'impédance d'entrée est voisine de l'impédance caractéristique 50 Ω, alors que l'impédance de sortie de ces circuits est très grande.

Une adaptation d'impédance, référencée 18, est nécessaire de façon à réaliser un transfert optimal de puissance entre les deux étages.

Le deuxième de ce circuit, constitué par le transistor à effet de champ $T_3$ monté en source commune, permet d'obtenir, si convenablement polarisé, le mélange des deux signaux avec un point de fonctionnement situé dans une partie non linéaire de sa courbe caractéristique $I_D = f(V_{GS})$. Le signal récupéré sur l'électrode de drain $D_3$ doit alors être filtré de telle sorte que l'on ne conserve que le signal de fréquence désiré, en l'espèce celui dont la fréquence est la différence des fréquences des deux signaux appliqués à l'entrée, soit dans ce cas particulier 1 GHz. Il est bien évident que ces nombres ne sont donnés qu'à titre d'illustration et ne sauraient en aucun cas être considérés comme une limitation de la présente invention.

La figure 4 preprésente un composant connu, à savoir un transistor double source. Ce transistor est connu de par exemple la publication PHILIPS TECHNICAL REVIEW, volume 39, n° 10, p. 269—276, de l'article intitulé »Low-noise microwave GaAs field effect transistor«, par P. BAUDET, M. BINET et D. BOCCON-GIBOD, notamment de la figure 1 de cet article.

Cependant, si ce composant est connu, il n'a jamais été imaginé que l'on pouvait appliquer sur les deux électrodes de source des signaux différents. Cette nouvelle structure et technologie subséquente n'ont été mises au point que pour réduire la résistance de grille, soit en mettant deux portions de grille en parallèle, soit en prenant contact au milieu de la grille.

L'idée principale de l'invention revient en l'application nouvelle, sur ce composant connu, de deux signaux de fréquences différentes, de telle sorte que l'on récupère sur l'électrode de drain un signal qui soit la combinaison additive des deux signaux appliqués sur les deux électrodes de source.

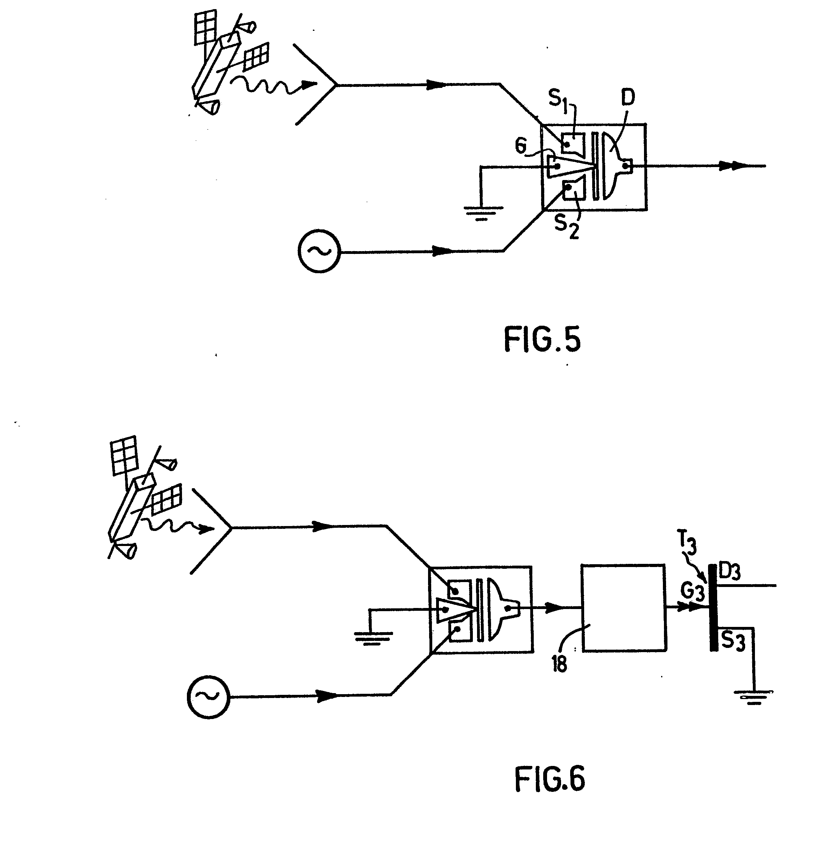

La figure 5 représente alors le nouveau circuit de combinaison selon la présente invention. Sur les deux électrodes de sources $S_1$ et $S_2$ de ce transistor DSFET (»dual-source field effect transistor«, ou transistor à effet de champ à double source) sont appliqués les deux signaux en provenance du satellite (12 GHz) et d'un oscillateur local (11 GHz), alors que l'électrode de grille G est reliée à la masse, par exemple par un trou métallisé au travers du substrat (par exemple en GaAs), et que le signal ainsi combiné est récupéré sur l'électrode de drain D.

Ce signal peut être alors appliqué par exemple à l'électrode de grille d'un transistor à effet de champ $T_3$, ainsi que représenté à la figure 6, de façon à assurer le mélange des deux signaux, un circuit d'adaptation 18 permettant d'assurer le transfert optimal de puissance, et le signal ainsi mélangé peut être récupéré sur l'électrode de drain $D_3$, éventuellement après filtrage, de façon à éliminer les fréquences indésirables et à ne conserver, en ce cas particulier, que la fréquence intermédiaire de 1 GHz.

## Revendication

1. Circuit de combinaison hyperfréquences, du type comprenant deux entrées et une sortie, au moyen duquel le signal de sortie obtenu est la somme des deux signaux d'entrée, caractérisé en ce qu'il comporte un seul transistor à effet de champ double source, monté en grille commune, alors que les deux signaux d'entrée sont appliqués sur les deux électrodes de source ($S_1$, $S_2$) et que le signal de sortie est obtenu sur l'unique électrode de drain (D).

2. Circuit de combinaison et de mélange hyperfréquences comportant un premier circuit de combinaison, selon la revendication 1, du type comprenant au moins deux entrées et une sortie, au moyen duquel le signal de sortie obtenu est le mélange des deux signaux d'entrée, caractérisé en ce que le signal de sortie de ce premier circuit est appliqué, au travers d'une adaptation d'impédance (18), à l'électrode de grille ($G_3$) d'un transistor à effet de champ ($T_3$), monté en source commune, dont la tension de polarisation est telle qu'il fonctionne dans une région de sa courbe $I_D = f(V_{GS})$ non linéaire, et que le signal de sortie de ce circuit de combinaison et de mélange est obtenu sur l'électrode de drain ($D_3$) de ce transistor à effet de champ ($T_3$).

3. Circuit selon l'une des revendications 1 ou 2, caractérisé en ce qu'il est réalisé de façon monolithique sur un substrat semiconducteur tel que de l'arséniure de gallium.

## Patentansprüche

1. UHF-Kombinationsschaltung mit zwei Eingängen und einem Ausgang, mit deren Hilfe das gewonnene Ausgangssignal die Summe der zwei Eingangssignale ist, dadurch gekennzeichnet, daß in dieser Schaltung ein einziger Feldeffekttransistor mit Doppelquelle in gemeinsamer Gateschaltung vorgesehen ist, wobei die zwei Eingangssignale an die zwei Source-Elektroden ($S_1$, $S_2$) gelegt werden und das Ausgangssignal an der einen Drainelektrode (D) empfangen wird.

2. UHF-Kombinations- und -Mischschaltung mit einer ersten Kombinationsschaltung und zumindest zwei Eingängen und einem Ausgang nach Anspruch 1, mit deren Hilfe das gewonnene Ausgangssignal die Mischung aus zwei Eingangssignalen, dadurch gekennzeichnet, daß das Ausgangssignal dieser ersten Schaltung über eine Impedanzanpassung (18) an die Gateelektrode ($G_3$) eines Feldeffekttransistors ($T_3$) in Sourceschaltung gelegt wird, dessen Polarisationsspannung derart ist, daß sie in einem Bereich ihrer nichtlinearen Kurve $I_D = f(V_{GS})$ arbeitet, und daß das Ausgangssignal dieser Kombinations- und Mischschaltung auf der Drainelektrode ($D_3$) dieses Feldeffekttransistors ($T_3$) ankommt.

3. Schaltung nach einem der Ansprüche 1 oder 2, dadurch gekennzeichnet, daß sie in monolithischer Form auf einem Halbleitersubstrat, z. B. aus Galliumarsenid, verwirklicht wird.

## Claims

1. A high-frequency combination circuit of the type comprising two inputs and one output, by means of which an output signal is obtained which is the sum of the two input signals, characterized in that it comprises a single dual source field effect transistor connected in common gate configuration, while the two input signals are applied to the two source electrodes ($S_1$, $S_2$), and in that the output signal is obtained at the single drain electrode (D).

2. A high-frequency combination and mixing circuit comprising a first combination circuit as claimed in Claim 1, of the type comprising at least two inputs and one output, by means of which an output signal is obtained which is the mixed product of the two input signals, characterized in that the output signal of this first circuit is applied via impedance adaptation means (18) to the gate electrode ($G_3$) of a field effect transistor ($T_3$) connected in common source configuration, whose bias voltage is such that it operates in a non-linear part of its curve $I_D = f(V_{GS})$, and in that the output signal of this combination and mixing circuit is obtained at the drain electrode ($D_3$) of this field effect transistor ($T_3$).

3. A circuit as claimed in either one of Claims 1 or 2, characterized in that it is obtained in a monolithical manner on a semiconductor substrate of, for example, gallium arsenide.

**FIG.1**

**FIG.2**

FIG.3

FIG.4

FIG.5

FIG.6

9